# EUROPÄISCHE PATENTANMELDUNG

(11) **EP 0 723 036 A1**
(43) Veröffentlichungstag der Anmeldung: **24.07.1996**
(21) Anmeldenummer: 95118514.9
(22) Anmeldetag: 24.11.1995
(51) Int. Cl.: C23C 14/50, C23C 14/56

(54) **Vorrichtung zur Beschichtung von Substraten**

(30) Priorität: 21.01.1995 DE 19501804
(71) Anmelder: LEYBOLD AKTIENGESELLSCHAFT, D-63450 Hanau (DE)
(72) Erfinder: Bähr, Martin, Dr., D-63594 Hasselroth (DE); Beisswenger, Siegfried, Dr., D-63755 Alzenau (DE); Bräuer, Günther, Dr., D-63579 Freigericht 2 (DE); Scherer, Michael, Dr., D-63517 Rodenbach (DE)

(57) **Zusammenfassung**

Bei einer Vorrichtung zur Beschichtung von Substraten (3, 3',...) mittels Kathodenzerstäubung in einer Vakuumanlage, bestehend aus einer Zerstäubungskammer, die mit zwei Kathoden (4, 5) mit Targets (6, 7) des zu zerstäubenden Werkstoffs ausgestattet ist und mittels der die als Gruppe zu betreibenden Kathoden (4, 5) sowie unterschiedlicher, in der Kammer einzustellender Verfahrensbedingungen verschiedenartige Schichtsysteme auf die zu beschichtenden Substrate (3, 3',...) aufbringbar sind und die Substrate mittels Carrier (8) vor die Kathoden-Gruppe und/oder an dieser vorbei bewegbar sind, ist der Carrier (8) mit mindestens einer Antriebseinheit (9, 9',...) ausgestattet, die die Substrate (3, 3',...) gegenüber dem Carrier (8) bewegt, vorzugsweise dreht, wobei die zu beschichtenden Flächen der Substrate sich in einer Ebene bewegen, die sich gegenüber den zu zerstäubenden Targetflächen (6, 7) der Kathodengruppe (4, 5) gleichsinnig erstreckt.

## Beschreibung

Die Erfindung betrifft eine Vorrichtung zur Beschichtung von Substraten entsprechend dem Oberbegriff des Patentanspruchs 1.

Es sind Beschichtungsverfahren bekannt, beispielsweise auf dem Gebiet der Großflächen-Glasbeschichtung für ebene, plattenförmige Substrate, die überwiegend in Durchlauf- oder sogenannten "Inline"-Anlagen erfolgt. Für die Beschichtung von Substraten mit unterschiedlichen Werkstoffen oder auch für die Aufbringung verschiedenartiger Schichtsysteme müssen die Beschichtungsanlagen so flexibel wie möglich angelegt sein und besitzen daher meist mehrere Zerstäubungskathoden und mehrere hintereinandergeschaltete Prozeßkammern.

Bekannt ist auch eine Vorrichtung zum Beschichten eines Substrats mit Werkstoffen, beispielsweise mit Metall (DE-OS 40 10 495), bestehend aus Stromquellen, welche mit in einer evakuierbaren Beschichtungskammer angeordneten Elektroden verbunden sind, die elektrisch mit Targets in Verbindung stehen, die zerstäubt werden und deren zerstäubte Teilchen sich auf dem Substrat niederschlagen, wobei in die Beschichtungskammer ein Prozeßgas einbringbar ist und die Targets aus einem oder mehreren zu zerstäubenden Werkstoffen jeweils in einem Winkel zur Ebene des Substrats gehalten sind, wobei sich die Hauptwanderungsrichtungen der Teilchenströme der auf das Substrat ausgerichteten Targets in einem Punkt schneiden.

Weiterhin ist eine Einrichtung zur Unterdrückung von Lichtbögen bei Gasentladungsvorrichtungen, mit wenigstens einer Elektrode und einer Spannungsquelle bekannt (DE-OS 41 27 505), bei der zwei Elektroden vorgesehen sind, die an der Spannungsquelle liegen und eine Schaltungsanordnung mit einem in eine erste Stromrichtung kurzschließbaren Parallelzweig zur Spannungsquelle, wobei die Spannungsquelle eine Wechselspannungsquelle ist.

Bekannt ist auch ein Verfahren zur Beschichtung eines Substrats durch reaktive Kathodenzerstäubung (DAS 25 13 216), bei den in einer evakuierbaren Kammer eine Anode und eine Zerstäubungselektrode aus leitfähigem Material angeordnet sind, zwischen denen ein Gasentladungsplasma aufrechterhalten wird, bei dem die Kammer ein unter einem bestimmten Partialdruck stehendes reaktives Gas enthält, welches in Reaktion mit dem Targetmaterial eine isolierende Verbindung bildet, wobei die an der Zerstäubungselektrode liegende Wechselspannung eine Frequenz aufweist, die größer als 400 Hz und kleiner als 60 000 Hz ist.

Der vorliegenden Erfindung liegt die Aufgabe zugrunde, eine Vorrichtung zum Beschichten von Substraten, vorzugsweise von optischen Elementen, wie Linsen oder dergleichen zu schaffen, die auch dann eine besonders gleichmäßige Beschichtung erlaubt, wenn die zu beschichtende Fläche gewölbt ist, wobei bei einem Durchlauf durch die Beschichtungsstation gleichzeitig mindestens zwei verschiedene Schichten aufbringbar sein sollen. Die Größe, bzw. die Längenausdehnung der Vorrichtung soll außerdem besonders kompakt sein.

Diese Aufgabe wird erfindungsgemäß dadurch gelöst, daß der die Substrate aufnehmende Carrier mit einer Antriebseinheit ausgestattet ist, die die Substrate gegenüber dem Carrier bewegt, vorzugsweise dreht, wobei die zu beschichtenden Flächen der Substrate sich in einer Ebene bewegen, die sich gegenüber den zu zerstäubenden Targetflächen in gleicher Richtung erstreckt. Mit Vorteil weisen die Targets der Kathoden eine rechteckige Konfiguration auf und sind in horizontaler Lage und paarweise parallel zum Substrat-Transportweg in der Prozeßkammer gehalten, wobei die zu zerstäubenden Flächen der Targets eines Kathodenpaares um einen Winkel geneigt zueinander angeordnet sind, derart, daß sich lotrecht zur Targetfläche und durch deren Mitte erstreckende Geraden in einem Punkt schneiden, der auf der den Kathoden abgewandten Seite der Substrate liegt.

Weitere Einzelheiten und Merkmale ergeben sich aus den Unteransprüchen und sind in diesen gekennzeichnet.

Die Erfindung läßt die verschiedensten Ausführungsmöglichkeiten zu; eine davon ist in den anhängenden Zeichnungen rein schematisch näher dargestellt und zwar zeigen:
- **Fig. 1**: die Seitenansicht eines Kathodenpaares mit seinen auf der den Substraten zugewandten Seiten angeordneten Targets und zwei Substrate die sich in ihrer Beschichtungsposition befinden und
- **Fig. 2**: die Darstellung der Kathoden-Gruppe gemäß Fig. 1 und der vor diesen angeordneten Substraten in Richtung des Substrat-Transportwegs gesehen.

Wie die Zeichnung zeigt, sind auf einem Carrier 8, der auf dem Bodenteil 11 der Prozeßkammer in einer Schiene 12 längsverschiebbar gehalten und geführt ist, Substrate 3, 3',... auf Wellen 10, 10',... gelagert, die zu diesem Zwecke mit Substrathalterungen 13, 13',... versehen sind. Den Substraten 3, 3',... gegenüberliegend sind zwei Kathoden (Kathodenpaar) 4, 5 in der Vakuumkammer vorgesehen, die um an einem Kathodenhalter 18 vorgesehenen Bolzen 14, 14',..., 15, 15',... schwenkbar in Pfeilrichtung C - D gelagert sind und deren Targets 6, 7 ... so auf die Substrate ausgerichtet sind, daß sich lotrecht zu den Targetflächen erstreckenden Geraden b, c in einem Punkt a treffen, der sich hinter den Substraten befindet. Die als planare Magnetrons ausgebildeten Kathoden können elektrisch einzeln betrieben werden oder aber beide über eine Wechsel-Stromquelle mit einer Mittelfrequenz angesteuert werden, so daß sich auf der den Substraten 3, 3',... zugekehrten Seiten der Kathoden 4, 5 entsprechende racetracks 16..., 17... einstellen. Die Kathoden 4, 5 weisen eine rechteckige Konfiguration auf und sind so angeordnet, daß sich jeweils ihre Längsrichtungen parallel dem Transportweg erstrecken.

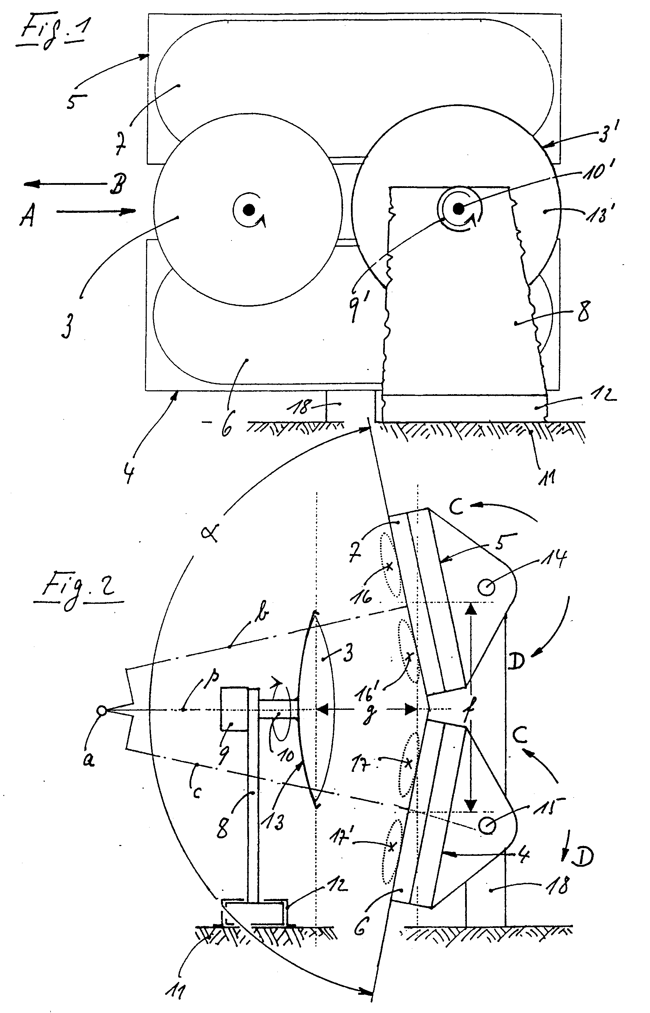

Der Carrier 8 wird in der Bewegungsrichtung A durch die Vakuumkammer bewegt, bis sich die Substrate 3, 3',... in der in der Zeichnung Fig. 1 dargestellten Position unmittelbar vor dem Kathodenpaar 4, 5 befinden. In dieser Position verharrt der carrier bis der gewünschte Beschichtungsvorgang beendet ist. Während des sputter-prozesses werden die Substrate 3, 3',... über die Motore 9, 9',... um die Symmetrieachse s in Rotation versetzt, wodurch eine besonders gleichmäßige Beschichtung erzielt wird. Nach beendetem Beschichtungsvorgang kann der Carrier 8/-je nach Ausbildung der Prozeßkammer entweder in Pfeilrichtung A weiterbewegt werden bis zu einer weiteren Kathodenstation, oder aber der Carrier 8 wird in Pfeilrichtung B zurückgefahren und aus der Prozeßkammer ausgeschleust.

Vor den Kathoden befindet sich mindestens eine Linse 3, die auf der Symmetrieachse s der Magnetronanordnung positioniert ist. Entsprechend der Länge der Magnetronanordnung 4, 5 kann jedoch die Anzahl der gleichzeitig zu beschichtenden Linsen 3, 3',... erhöht werden.

Zur Erzielung einer gleichförmigen Beschichtung auf Linsen verschiedener Durchmesser, Formen und Krümmungen (konkav, konvex) sind folgende Maßnahmen vorgesehen:
**a)** Die Linse rotiert um ihren Mittelpunkt, wobei die Winkelgeschwindigkeit eine Funktion der Zeit sein kann
**b)** die Position der Kathoden 4, 5 relativ zum Substrat 3, 3',... ist variabel gestaltet, wobei die Abstände f und g und der Winkel α (Fig. 2) frei einstellbar sind.

Mit einer einzigen Kathodenanordnung kann ein Vielfachschichtsystem, bestehend aus SiO₂- und Si₃N₄-Schichten, in beliebiger Kombination abgeschieden werden. Der Wechsel zwischen den Schichten erfolgt durch einen Wechsel des Reaktivgases. Die Schichten dienen zur Entspiegelung, als Kratzschutz, zur Hydrophobie oder zu einer Kombination dieser Funktionen.

Auch Entspiegelungsschichten können aus einem Vielfachschichtsystem von SiO₂- und Si₃N₄-Schichten bestehen.

Mit der beschriebenen Anordnung können auch Gradientenschichten für die Entspiegelung erzeugt werden, wobei durch zeitliche Regelung der Reaktivgasflüsse (O₂,N₂) der Brechungsindex über die Schichtdicke kontinuierlich erhöht bzw. erniedrigt werden kann.

Mit mehreren Kathoden-Anordnungen, die hintereinandergeschaltet sind, sind neben dem Material Si auch beliebige andere Materialien oder deren Legierungen verwendbar mit dem Vorteil hochbrechende Verbindungsschichten für optische Vielfachschichtsysteme aufbringen zu können.

Schließlich kann eine Vorrichtung des beschriebenen Typs mit weiteren Beschichtungsvorrichtungen z. B. zum PEVCD, DC-Sputtern oder RF-Sputtern in einundderselben Prozeßkammer kombiniert werden.

### Auflistung der Einzelteile

- 3, 3',...: Substrat
- 4: Kathode
- 5: Kathode
- 6: Target
- 7: Target
- 8: carrier
- 9, 9',...: Antriebseinheit, Motor
- 10, 10',...: Welle
- 11: Bodenteil der Vakuumkammer
- 12: Schiene
- 13, 13',...: Substrathalterung
- 14, 14',...: Bolzen
- 15, 15'...: Bolzen
- 16, 16',...: racetrack
- 17, 17',...: racetrack
- 18: Kathodenhalter

## Patentansprüche

1. Vorrichtung zur Beschichtung von Substraten (3, 3',...) mittels Kathodenzerstäubung in einer Vakuumanlage, bestehend aus mindestens einer Zerstäubungskammer, die mit mindestens zwei Kathoden (4, 5) mit Targets (6, 7) des zu zerstäubenden Werkstoffs ausgestattet ist und mittels der die als Gruppe zu betreibenden Kathoden (4, 5) sowie unterschiedlicher, in der Kammer einzustellender Verfahrensbedingungen verschiedenartige Schichtsysteme auf die zu beschichtenden, vorzugsweise gebogenen Substrate (3, 3',...) aufbringbar sind und die Substrate mittels eines Transportsystems, beispielsweise mittels Carrier (8) vor die Kathoden-Gruppe und/oder an dieser vorbei bewegbar sind, **dadurch gekennzeichnet**, daß der die Substrate (3, 3',...) aufnehmende Carrier (8) mit mindestens einer Antriebseinheit (9, 9',...) ausgestattet ist, die die Substrate (3, 3',...) gegenüber dem carrier (8) bewegt, vorzugsweise dreht, wobei die zu beschichtenden Flächen der Substrate sich in einer Ebene bewegen, die sich gegenüber den zu zerstäubenden Targetflächen (6, 7) der Kathodengruppe (4, 5) gleichsinnig erstreckt.

2. Vorrichtung nach Anspruch 1, **dadurch gekennzeichnet**, daß die Targets (6, 7) der Kathoden (4, 5) eine längliche, parallelepipede Konfiguration aufweisen und in horizontaler Lage und paarweise gleichsinnig zum Substrat-Transportweg in der Zerstäubungskammer gehalten sind.

3. Vorrichtung nach den Ansprüchen 1 und 2, **dadurch gekennzeichnet**, daß die Flächen der Targets (6, 7) eines Kathodenpaares (4, 5) zueinander um einen Winkel (α) geneigt angeordnet sind, wobei sich lotrecht zur Targetfläche und durch deren Flächenmittelpunkt erstreckende Geraden (b, c) in einem Punkt (a) schneiden, der auf der den Kathoden (4, 5) abgewandten Seite der Substrate (3, 3',...) liegt.

4. Vorrichtung nach den vorhergehenden Ansprüchen, **dadurch gekennzeichnet**, daß jedes auf dem durch die Zerstäubungskammer transportierbaren Carrier (8) gehaltene Substrat (3, 3',...) auf einer drehbaren Welle (10) befestigt ist, deren Längsachse bzw. Rotationsachse jeweils durch den Schnittpunkt (a) der lotrecht auf den beiden Targetflächen stehenden beiden Geraden (b, c) verläuft und den Winkel (α) unter dem sich diese beiden Geraden schneiden halbiert.

5. Vorrichtung nach einem oder mehreren der vorhergehenden Ansprüchen, **dadurch gekennzeichnet**, daß der Carrier (8) durch die Zerstäubungskammer hindurch bewegbar ist und die Substrate (3, 3',...) die Prozeßkammer mehrfach in Bewegungsrichtung (A) sowie in entgegengesetzter Richtung (B) im sogenannten Multipass-Mode durchlaufen.

6. Vorrichtung nach einem oder mehreren der vorhergehenden Ansprüche, **dadurch gekennzeichnet**, daß die Drehung der Substrate (3, 3',...) mit variabler Geschwindigkeit erfolgt.

7. Vorrichtung nach einem oder mehreren der vorhergehenden Ansprüche, **dadurch gekennzeichnet**, daß die Stellung der auf dem Kathodenhalter gelagerten Kathoden (4, 5) zur Ebene der Substrate (6, 7) einstellbar ist, wobei sich der von den beiden Targetebenen eingeschlossene Winkel (α) ändert.

8. Vorrichtung nach einem oder mehreren der vorhergehenden Ansprüche, **dadurch gekennzeichnet**, daß die Kathoden (4, 5) eines Kathodenpaares mit einer Wechselspannung betrieben werden, deren Frequenz zwischen 100 Hz und 60 000 Hz liegt.

9. Vorrichtung nach einem oder mehreren der vorhergehenden Ansprüchen, **dadurch gekennzeichnet**, daß die Substrate mit einem Vielfachschichtsystem versehen werden, bestehend aus SiO₂ und Si₃N₄-Schichten, wobei die Schichtenfolge durch einen wechselnden Einlaß der Prozeßgase (O₂, N₂) erfolgt, wobei der Targetwerkstoff Si ist.
